# EUROPEAN PATENT APPLICATION

(11) **EP 4 517 829 A1**
(43) Date of publication of application: **05.03.2025**
(21) Application number: 23193923.2
(22) Date of filing: 29.08.2023
(51) Int. Cl.: H01L 29/06, H01L 29/78, H01L 21/336, H01L 29/66

(54) **EDGE TERMINATION REGION OF SUPERJUNCTION DEVICE**

(71) Applicant: Nexperia B.V., 6534 AB Nijmegen (NL)
(72) Inventor: Yin, Randy, Shanghai (CN); Chen, Fan, Shanghai (CN); Wang, Zhengkang, Shanghai (CN)
(74) Representative: Pjanovic, Ilija

(57) **Abstract**

A semiconductor power device having an active region and an edge termination region surrounding the active region. The device comprises a plurality of drift regions of a first conductivity type and a plurality of partition regions of a second conductivity type alternately in contact with each other, to form a plurality of mutually parallel p-n junctions extending in a vertical direction between adjacent drift regions and partition regions. In the edge termination region, the depths of adjacent drift regions and partition regions decreases through the edge termination region. The device further comprises one or more electrically floating regions of a first conductivity type within the edge termination region.

## Description

### Technical Field

The present disclosure relates to a power semiconductor device, particularly but not exclusively, the present disclosure relates to an edge termination region of a super junction metal-oxide semiconductor field-effect transistor (MOSFET).

### Background

Power semiconductor devices such as metal-oxide semiconductor field-effect transistors (MOSFETs) or insulated-gate bipolar transistors (IGBTs) require a high breakdown voltage. It is possible to achieve a high value of breakdown voltage (BV) in the active regions of super junction MOSFETS. However, the breakdown voltage of state-of-the-art super-junction devices is reduced due to the charge balance interruption or discontinuity at the edge termination region.

US 10,205,009 B2 and US 9,595,596 B2 both relate to superjunction semiconductor devices.

### Summary

Aspects and preferred features are set out in the accompanying claims.

According to a first aspect of the disclosure, there is provided a semiconductor power device having an active region and an edge termination region surrounding the active region, wherein the edge termination region is located laterally between the active region and a side surface of the semiconductor device, the device comprising:
a semiconductor substrate comprising a semiconductor substrate region of a first conductivity type;
a plurality of drift regions of a first conductivity type and a plurality of partition regions of a second conductivity type each disposed over the semiconductor substrate region and alternately in contact with each other, to form a plurality of mutually parallel p-n junctions extending in a vertical direction between adjacent drift regions and partition regions,
wherein, in the edge termination region, two or more partition regions of the plurality of partition regions extend to form a layer of a second conductivity type over two or more drift regions of the plurality of drift regions, and wherein, the depths of adjacent drift regions and partition regions decreases through the edge termination region, from the transition region to the side surface of the device; and
one or more electrically floating regions of a first conductivity type located over the layer of a second conductivity type and within the edge termination region.

The electrically floating regions improve the charge balance and thus increase the breakdown voltage of the edge termination region. As the depths of adjacent drift regions and partition regions decreases through the edge termination region, the edge termination length of the device can be significantly reduced.

In the active area, one or more drift regions of the plurality of drift regions may extend such that the partition regions within the active region form physically separated partition regions.

The semiconductor power device may further comprise a plurality of floating pillar regions of a second conductivity type. Each floating pillar region of a second conductivity type may be located under a partition region of a second conductivity type.

The semiconductor power device may further comprise an insulator layer formed over the electrically floating regions.

The device may further comprise a transition region located laterally between the active region and the edge termination region.

The layer of a second conductivity type may laterally extend over one or more drift regions of the plurality of drift regions within the transition region.

Each of the plurality of pillars of a second conductivity type may comprise a plurality of implant regions of a second conductivity type arranged over one another along the depth of the pillars of a second conductivity type.

Each of the plurality of pillars of a first conductivity type may comprise a plurality of implant regions of a first conductivity type arranged over one another along the depth of the pillars of a first conductivity type.

The one or more electrically floating regions of a first conductivity type may form a plurality of laterally separated concentric ring structures.

Each one or more electrically floating regions of a first conductivity type may have substantially the same width.

The one or more electrically floating regions of a first conductivity type may form a variation of lateral doping (VLD) structure. The VLD structure has the capability to support high reverse bias voltage.

The semiconductor power device may further comprise a buffer region of the first conductivity type located above the semiconductor substrate region of a first conductivity type. The buffer region of a first conductivity type may have a lower doping concentration than the semiconductor substrate region of a first conductivity type.

The device may further comprise a channel stop region located laterally between the edge termination structure and a side surface of the semiconductor device. The channel stop region may extend to the side surface of the semiconductor device. The channel stop region may have a higher doping concentration than the drift regions.

The device may comprise a super junction power device.

The device may comprise a metal-oxide semiconductor field-effect transistor (MOSFET).

According to a further aspect of the disclosure, there is provided a method of manufacturing a semiconductor power device having an active region and an edge termination region surrounding the active region, wherein the edge termination region is located laterally between the active region and a side surface of the semiconductor device, the method comprising:
providing a semiconductor substrate comprising a first region of a first conductivity type;
forming a plurality of drift regions of a first conductivity type and a plurality of partition regions of a second conductivity type over the semiconductor substrate region and alternately in contact with each other, to form a plurality of mutually parallel p-n junctions extending in a vertical direction between adjacent drift regions and partition regions,
wherein, in the edge termination region, two or more partition regions of the plurality of partition regions extend to form a layer of a second conductivity type over two or more drift regions of the plurality of drift regions, and wherein the depths of adjacent drift regions and partition regions decreases through the edge termination region, from the transition region to the side surface of the device; and
forming one or more electrically floating regions of a first conductivity type located over the layer of a second conductivity type and within the edge termination region.

Forming the plurality of drift regions and the plurality of partition regions, and forming the one or more electrically floating regions of a first conductivity type, may comprise performing each of the steps (i) to (v) one or more times:
(i) depositing a semiconductor layer over the semiconductor substrate region;
(ii) forming a first mask over the semiconductor layer. The first mask may expose an upper surface of a first plurality of regions of the semiconductor layer. The first plurality of regions may be laterally spaced from each other;
(iii) selectively doping the first plurality of regions of the semiconductor layer to form a first plurality of regions of a first conductivity type;
(iv) forming a second mask over the semiconductor layer. The second mask may expose an upper surface of a second plurality of regions of the semiconductor layer. The second plurality of regions may be laterally spaced from each other and may be located between adjacent regions of the first plurality of regions of a first conductivity type;
(v) selectively doping the second plurality of regions of the semiconductor layer to form a first plurality of regions of a second conductivity type.

Each first mask and/or each second mask may expose a further region in addition to the exposed regions of the first mask or second mask on a previously deposited semiconductor layer.

An exposed region of the first mask that is closest to the side surface of the device or an exposed region of the second mask that is closest to the side surface of the device has a different width to other exposed regions of the first mask and the second mask between the exposed region closest to the side surface and the active region.

The exposed region of the first mask that is closest to the side surface of the device or the exposed region of the second mask that is closest to the side surface of the device may be smaller in width than the other exposed regions of the first mask and the second mask between the exposed region closest to the side surface and the active region.

The exposed region of the first mask that is closest to the side surface of the device or the exposed region of the second mask that is closest to the side surface of the device may be approximately half the width of the other exposed regions of the first mask and the second mask between the exposed region closest to the side surface and the active region.

The further exposed regions of each of the semiconductor layers that is closest to the side surface of the device may have different widths such that they extend to substantially the same lateral position in the device.

The exposed region of the first mask that is closest to the side surface of the device or the exposed region of the second mask that is closest to the side surface of the device may be used to herein refer to the exposed region forming a drift region or a partition region and may not be used to refer to the region forming the channel stop region.

The method may further comprise: depositing a further semiconductor layer over the previously deposited semiconductor layers; forming a mask over the further semiconductor layer, wherein the mask may expose an upper surface of a plurality of regions of the further semiconductor layer; and selectively doping the plurality of regions of the further semiconductor layer to form a plurality of regions of a second conductivity type. The regions of the further semiconductor layer may be substantially aligned with the plurality of regions of a second conductivity type.

The method may further comprise: depositing an additional further semiconductor layer over the previously deposited semiconductor layers; forming a mask over the additional further semiconductor layer, wherein the mask may expose an upper surface of a plurality of regions of the additional further semiconductor layer; and selectively doping the plurality of regions of the additional further semiconductor layer to form a plurality of island regions of a first conductivity type in the edge termination region. The regions of the additional further semiconductor layer may be substantially aligned with the plurality of regions of a second conductivity type in the edge termination region. The mask may not expose the additional further semiconductor layer in the active region.

### Brief Description of the Drawings

Some preferred embodiments of the disclosure will now be described, by way of example only, and with reference to the accompanying drawings, in which:
Figure 1 illustrates schematically a variation of lateral doping (VLD) edge termination region of a power semiconductor device according to an embodiment of the disclosure;
Figure 2 illustrates schematically a ring structure edge termination region of a power semiconductor device according to an embodiment of the disclosure;
Figure 3 illustrates the p-type doping concentration of the devices shown in Figures 1 and 2;
Figure 4 illustrates schematically a first set of steps in a method of manufacturing a device according to an embodiment of the disclosure;
Figure 5 illustrates schematically a second set of steps in a method of manufacturing a device according to an embodiment of the disclosure;
Figure 6 illustrates schematically a third set of steps in a method of manufacturing a device according to an embodiment of the disclosure;
Figure 7 illustrates a doping profile of a device shown in Figure 6;
Figure 8 illustrates schematically a fourth set of steps in a method of manufacturing a device according to an embodiment of the disclosure;
Figure 9 illustrates schematically a fifth set of steps in a method of manufacturing a device according to an embodiment of the disclosure;
Figure 10 illustrates a doping profile of a device shown in Figure 9;
Figure 11 illustrates schematically a sixth set of steps in a method of manufacturing a device according to an embodiment of the disclosure;
Figure 12 shows simulated breakdown voltages of the devices shown in Figures 1 and 2;
Figure 13 shows an alternative edge termination region of a power semiconductor device according to an embodiment of the disclosure;
Figure 14 shows an alternative edge termination region of a power semiconductor device according to an embodiment of the disclosure; and
Figure 15 shows an alternative edge termination region of a power semiconductor device according to an embodiment of the disclosure.

### Detail Description of the Preferred Embodiments

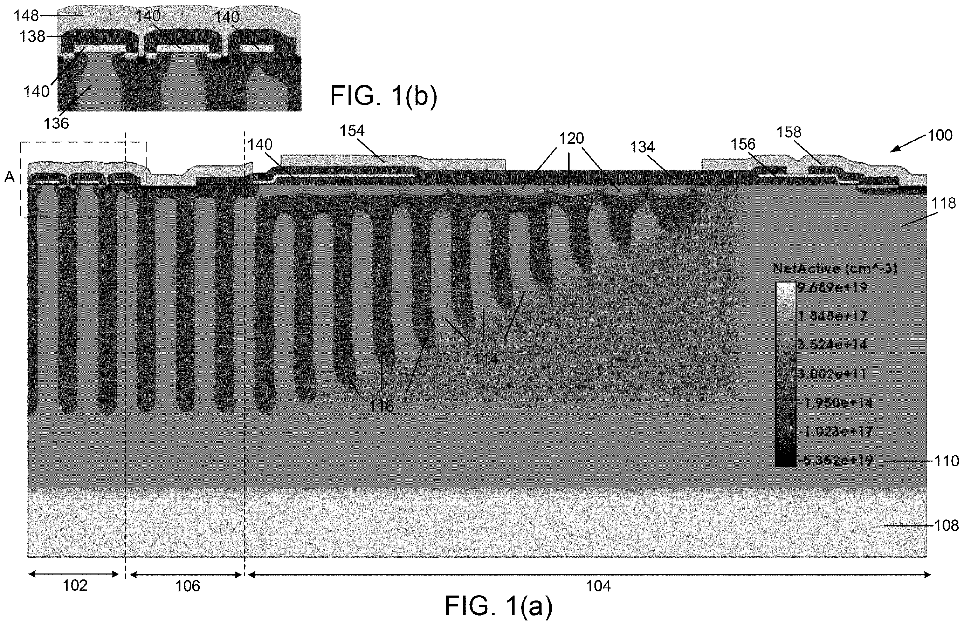

Figure 1(a) illustrates schematically a variation of lateral doping (VLD) edge termination region of a power semiconductor device 100 according to an embodiment of the disclosure. Figure 1(b) shows the area A of Figure 1(a) in greater detail. The power semiconductor device 100 includes a semiconductor substrate. In examples, the semiconductor substrate is formed of silicon, although other semiconductor materials may be used.

The device 100 includes three regions: an active region 102 that is used for current conduction, an edge termination region 104, and a transition region 106. The active region 102 is located in the centre of the semiconductor device, whilst the edge termination region 104 surrounds the active region 102 and is located between the active region 102 and the side surfaces of the semiconductor device. The transition region 106 also surrounds the active region 102 and is located between the active region 102 and the edge termination region 104. It will be understood that Figure 1 illustrates a cross-section through only a portion of a semiconductor device.

In this embodiment, the semiconductor substrate includes an n-type substrate region 108. An n-type buffer region or drift region 110 is located over the n-type substrate region 108. The buffer region 110 has a lower doping concentration than the n-type substrate region 108.

A plurality of n-type pillars 114 and a plurality of p-type pillars 116 (or partition regions) are located over the drift region 110. The n-type pillar regions 114 extend from the drift region 110 and may be considered as further drift regions. The n-type pillars 114 and the p-type pillars 116 are alternately in contact with each other, such that each p-type pillar 116 is located between two adjacent n-type pillars 114, to form parallel p-n junctions extending in a vertical direction between adjacent n-type pillars 114 and p-type pillars 116.

In the edge termination region 104, the n-type pillar regions 114 and the p-type pillar regions 116 have different lengths and thus extend to different depths within the semiconductor substrate. The pillar with the greatest depth or height is located closest to the transition region 106 and the pillar with the smallest depth is located closest to the side surface of the device, with the n-type pillars 114 and p-type pillars 116 decreasing in depth towards the side surface of the device. The pillar with the greatest depth has the same depth as the n-type pillars within the transition region 106 and active region 102, and each subsequent n-type pillar 114 or p-type pillar has a depth smaller than an adjacent pillar. By providing the n-type pillars 114 and p-type pillars 116 in this triangle arrangement, the edge termination length of the device can be significantly reduced.

In the active region 102, n-type doped junction field electron transistor (JFET) regions 136 are located over the n-type pillars 114 such that the n-type doped regions extend to an upper surface of the semiconductor substrate. A gate polysilicon region 140 is located over the JFET n-type region 136, and is used to control the conduction channel in the active region. A gate insulation region 138, such as a silicon dioxide layer, is located over the gate polysilicon region 140. A source metal layer 148 is located on an upper surface of the device, over the gate insulation region 148.

In the edge termination region 104 and the transition region 106, a p-type layer 120 is located over the n-type pillars 114. The p-type layer 120 extends from the p-type pillars 116.

In the edge termination region 104, a plurality of n-type island regions 122 are located over the p-type layer 120 and at a top surface of the semiconductor substrate. The island regions 122 are electrically isolated or decoupled from the surrounding components of the device. The n-type island regions 122 are formed at a top surface of the semiconductor substrate, and an insulating layer 134, such as a silicon dioxide layer, is formed over the n-type island regions 122. In comparison to state-of-the-art devices, the floating n-type island regions improve the charge balance and thus increase the breakdown voltage of the edge termination region.

A gate metal layer 154 is formed over the insulating layer 134. A polysilicon field plate 156 is located over the channel stop region 118, and a metal field plate 158 is located over the polysilicon field plate.

In the example shown in Figure 1, the individual island regions 122 are wider towards the active area 102 and are narrower towards the side surface of the device, to provide a VLD edge termination region. The VLD edge termination region has a doping profile where the doping concentration of the island regions 122 is gradually reduced from to the source region to the drain region, which provides a more uniform surface electric field distribution so that breakdown voltage is improved. This can be achieved by using a mask with different width openings exposing the regions that form the island regions 122. The VLD edge termination region has the capability to support a high reverse bias voltage.

A channel stop region 118 is located at a side surface of the semiconductor device, at an opposite side of the edge termination region 104 to the active region 102. The channel stop region 118 includes an n-type region having a higher doping concentration than a region of the semiconductor substrate laterally adjacent to the channel stop region 118. The channel stop region 118 prevents conduction channels being formed at the edge of the device.

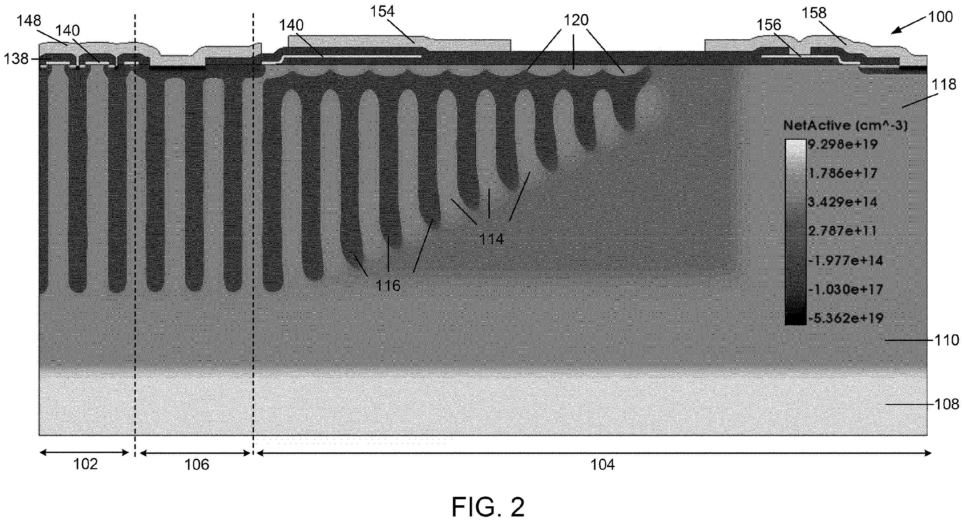

It will be understood, that the island regions 122 may alternatively have substantially the same width and same doping concentration, and therefore form a ring termination structure such as that shown in Figure 2. Many of the features shown in Figure 2 are the same as those shown in Figure 1 and therefore carry the same reference numerals. It will also be appreciated that the gate contact area will have the same structure as that shown in Figure 1(b).

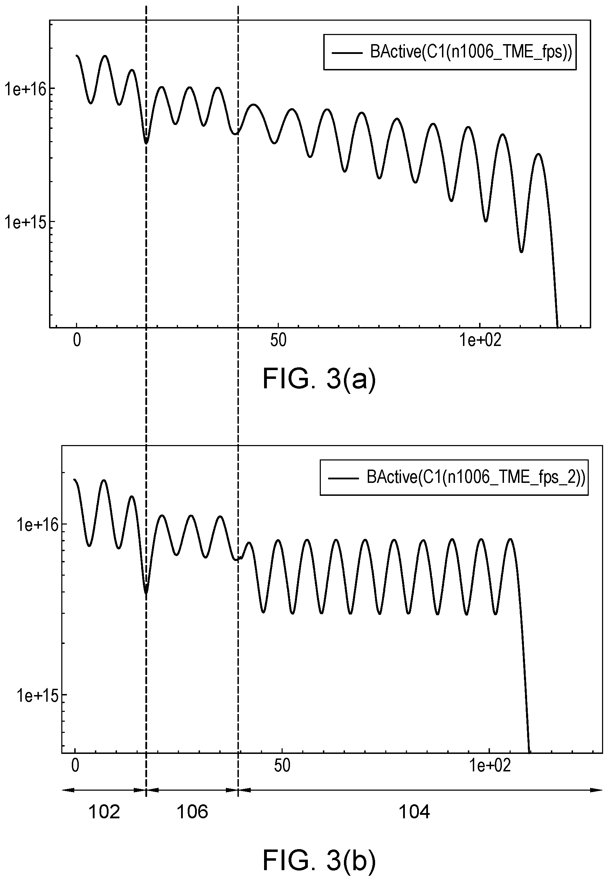

Figure 3(a) illustrates the p-type doping concentration of the device shown in Figure 1, and Figure 3(b) illustrates the p-type doping concentration of the device shown in Figure 2. For the VLD edge termination region, the p-type doping concentration (in this example, the boron doping concentration) shown in Figure 3(a) decreases from the transition region 106 towards the side surface of the device (in this example, shown as left to right) within the edge termination region 104. For the ring termination structure, the p-type doping concentration (in this example, the boron doping concentration) shown in Figure 3(b) is substantially constant between the n-type islands 122.

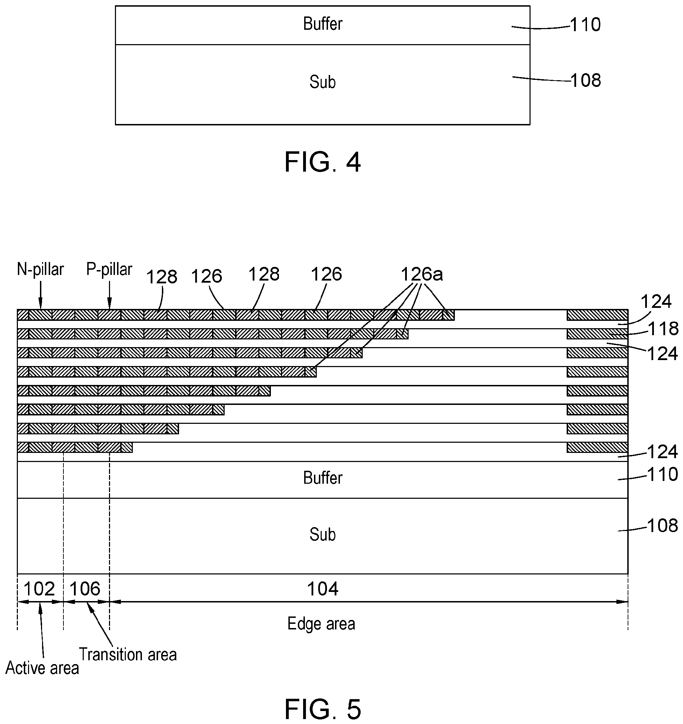

Figure 4 illustrates schematically a first set of steps in a method of manufacturing a semiconductor device, such as that shown in Figure 1 or 2. This involves forming a semiconductor substrate having an n-type substrate region 108 and a buffer region 110 over the n-type substrate region 108. The buffer region 110 can be thermally grown on the substrate region 108.

Figure 5 illustrates schematically a second set of steps in a method of manufacturing a semiconductor device. The steps of Figure 5 are performed after the steps shown in Figure 4. The steps (i) to (v) are each performed in turn a plurality of times. In the example shown in Figure 5, the steps (i) to (v) are performed 7 times, though they may be performed less or more times to form n-type pillars 114 and p-type pillars 116 of different depths.

The steps of Figure 5 are:
(i) a semiconductor layer 124 is deposited over the buffer region 110. Subsequent semiconductor layers are deposited over previously deposited semiconductor layers. The semiconductor layers 124 may be deposited using epitaxial growth;
(ii) a first mask is formed over the semiconductor layer 124. The first mask exposes an upper surface of a plurality of laterally spaced regions of the semiconductor layer 124 that will be doped with n-type doping. For example, the first mask may expose all the regions that will subsequently become n-type regions (the n-type pillar regions and the channel stop region). Each of the exposed laterally spaced regions are substantially the same width, with the exception of the channel stop region 118 and the exposed region of each semiconductor layer 126a that is closest to the side surface of the device. Each exposed region 126a of the semiconductor layers that is closest to the side surface of the device has a width that is smaller than the width of other exposed regions. In the example shown, the exposed region 124 of each semiconductor layer that is closest to the side surface of the device is approximately half the width of the other exposed regions. This improves the charge balance, and thus increases the breakdown voltage, of the fabricated device;
(iii) the regions exposed using the mask of step (ii) are selectively doped by implanting an n-type dopant, to form a plurality of n-type drift regions 126 and a plurality of channel stop regions 118. In examples, this is performed using vapour diffusion. In examples, the n-type dopant is phosphorus, however it will be understood that other n-type implant elements or dopants may be used;
(iv) a second mask is formed over the semiconductor layer 124. The second mask exposes an upper surface of a plurality of laterally spaced regions of the semiconductor layer 124 that will be doped with p-type doping. For example, the second mask may expose all the regions that will become the p-type pillar regions. The regions are exposed by the second mask are located between adjacent n-type drift regions 126. With the exception of the channel stop region 118 and the exposed region 126a of each semiconductor layer 124 that is closest to the side surface of the device, the regions exposed by the first mask and the second mask have approximately the same width;
(v) the regions exposed using the mask of step (iv) are selectively doped by implanting a p-type dopant, to form a plurality of p-type partition regions 128. In examples, this is performed using diffusion of Boron.

Each time step (ii) is performed, the first mask exposes an additional region of the semiconductor layer, such that each layer has an additional n-type drift region 126, wherein only the exposed region of each semiconductor layer 126a that is closest to the side surface of the device is smaller than the others. Each time step (iv) is performed, the second mask also exposes an additional region of the semiconductor layer, such that each layer has an additional p-type partition region 128. It will be appreciated, that steps (ii) and (iii), and steps (iv) and (v) may be swapped in order so that the p-type regions are formed before the n-type regions.

Steps (i) to (v) are performed such that each semiconductor layer 124 has a repeating pattern of alternating n-type drift regions 126 and p-type partition regions 128, with the region closest to the channel stop region 118 being an n-type drift region.

After performing steps (i) to (v) a plurality of times, the following further steps are performed:
(vi) a further semiconductor layer 130 is deposited over the semiconductor layers 124 previously deposited. The semiconductor layer 130 may be deposited using epitaxial growth;
(vii) a first mask is formed over the semiconductor layer 130. The first mask exposes an upper surface of a plurality of laterally spaced regions of the semiconductor layer 130 that will be doped with n-type doping. The first mask over semiconductor layer 130 exposes the same regions as the first mask used in the final iteration of step (ii), though the exposed region 126a of the semiconductor layer 130 that is closest to the side surface of the device has the same width as the other exposed regions;
(viii) the regions exposed using the mask of step (vii) are selectively doped, to form a further plurality of n-type drift regions 126 and a layer of the channel stop region 118. The doping concentration implanted in step (viii) is the same doping concentration implanted in step (iii). In examples, this is performed using vapour diffusion of Phosphorus;
(ix) a second mask is formed over the semiconductor layer 130. The second mask exposes an upper surface of a plurality of laterally spaced regions of the semiconductor layer 130 that will be doped with p-type doping. For example, the second mask may expose all the regions that will become the p-type pillar regions. The second mask over semiconductor layer 130 exposes the same regions as the second mask used in the final iteration of step (iv), though the second mask over semiconductor layer 130 exposes an additional region closest to the side surface of the device;
(x) the regions exposed using the mask of step (ix) are selectively doped, to form a further plurality of p-type partition regions 128. The doping concentration implanted in step (x) is the same doping concentration implanted in step (v) In examples, this is performed using vapour diffusion of Boron.

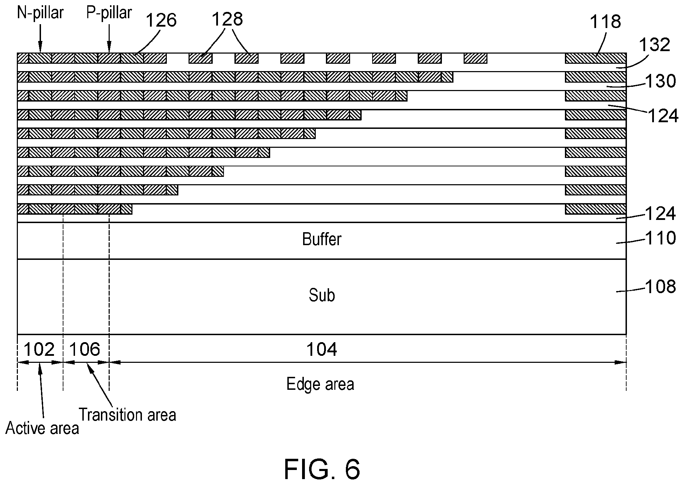

Figure 6 illustrates schematically a third set of steps in a method of manufacturing a semiconductor device. The steps of Figure 6 are performed after the steps shown in Figure 5.

The steps of Figure 6 are:
(xi) a further semiconductor layer 132 is deposited over the semiconductor layers 130 previously deposited in the steps shown in Figure 5. The semiconductor layer 132 may be deposited using epitaxial growth;
(xii) a first mask is formed over the semiconductor layer 132. The first mask exposes an upper surface of a plurality of laterally spaced regions of the semiconductor layer 132 that will be doped with n-type doping. The first mask of Figure 6 exposes the same regions as the first mask of Figure 5 in the active region 102 and transition region 106, and in the channel stop region 118, but exposes only a single region above the n-type drift regions in the edge termination region 104. The exposed region in the edge termination region 104 is closest to the transition region 106. This means that only a single n-type drift region 126 is formed in the edge termination region 104 of the semiconductor layer 132;
(xiii) the regions exposed using the mask of step (xii) are selectively doped, to form a further plurality of n-type drift regions 126 and a layer of the channel stop region 118. The doping concentration implanted in step (viii) is the same doping concentration implanted in step (iii). In examples, this is performed using vapour diffusion of Phosphorus;
(xiv) a second mask is formed over the semiconductor layer 132. The second mask exposes an upper surface of a plurality of laterally spaced regions of the semiconductor layer 132 that will be doped with p-type doping. For example, the second mask may expose all the regions that will become the p-type pillar regions. The second mask of Figure 6 exposes the same regions as the second mask formed over semiconductor layer 130 in step (ix) of Figure 6;
(xv) the regions exposed using the mask of step (xiv) are selectively doped, to form a further plurality of p-type partition regions 128. The doping concentration implanted in step (xv) is the same doping concentration implanted in steps (v) and (x). In examples, this is performed using vapour diffusion of Boron.

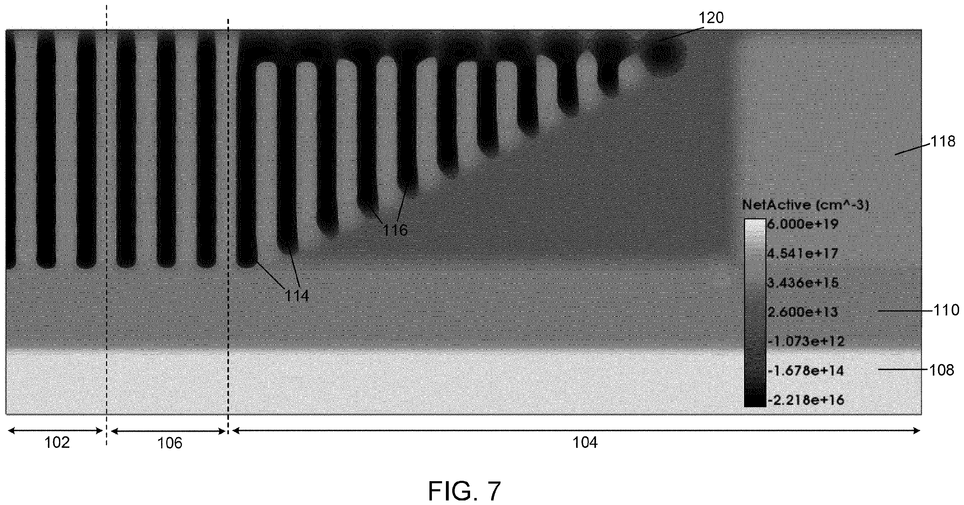

After vapour diffusion of Boron and Phosphorus, as described in relation to Figures 5 and 6, a further step of driving-in the dopants is performed to further diffuse or redistribute the dopants. The diffusion length of the initial diffusion is generally less than the diffusion length of the drive-in diffusion, and therefore the drive-in process causes the dopants to diffuse further into the semiconductor substrate. The drive-in process increases the temperature of the wafer and causes the impurities deposited on the surface of the semiconductor layers to be diffused into the semiconductor layers. This causes the n-type pillars 114 and the p-type pillars 116 to be formed from the separate n-type drift regions 126 and the separate p-type partition regions 128 respectively. This also causes the layers of the channel stop region 118 to become a single region, and causes the p-type partition layers 128 formed in the steps shown in Figure 6 to become the p-type layer 120 located over the n-type pillars 114 and the p-type pillars 116 in the edge termination region 104. Figure 7 illustrates a doping profile of a device shown in Figure 6 once the drive-in process has been performed.

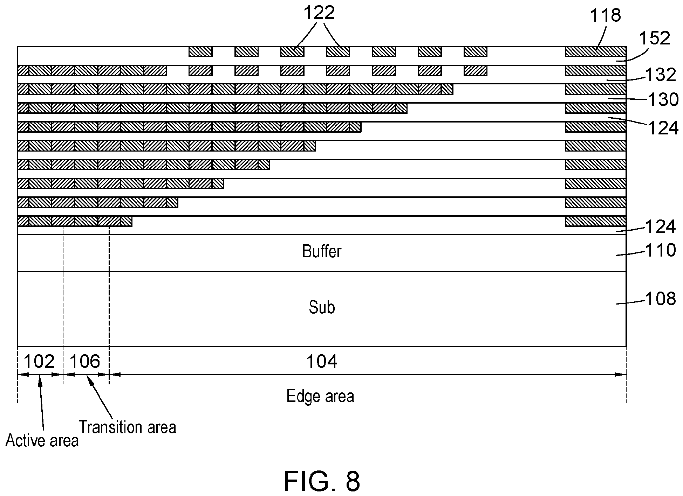

Figure 8 illustrates schematically a fourth set of steps in a method of manufacturing a semiconductor device. The steps of Figure 8 are performed after the steps shown in Figure 6.

The steps of Figure 8 are:
(xvi) an additional further semiconductor layer 152 is deposited over the semiconductor layer 132 previously deposited in the steps shown in Figure 6. The semiconductor layer 152 may be deposited using epitaxial growth;
(xvii) a mask is formed over the semiconductor layer 152. The mask exposes an upper surface of a plurality of laterally spaced regions of the semiconductor layer 152 that will be doped with n-type doping. The mask of Figure 8 exposes the same regions in the edge termination region 104 as the second mask formed over the semiconductor layer 132 in step (xiv) shown in Figure 6, and exposes the channel stop region 118. The mask of Figure 8 does not expose any regions of the active region 102 or the transition region 106, and does not expose any regions above the previously formed n-type drift regions 126 in the edge termination region 104;
(xviii) the regions exposed using the mask of step (xvii) are selectively doped, to form a plurality of n-type island regions 122 and a further layer of the channel stop region 118. The doping concentration implanted in step (xviii) may be the same doping concentration implanted in steps (iii), (viii), and (xiii). In examples, this is performed using vapour diffusion of Phosphorus.

After vapour diffusion of Phosphorus, as described in relation to Figure 8, another further step of driving-in the diffused dopants is performed. The drive-in process increases the temperature of the wafer and causes the impurities deposited on the surface of the semiconductor layers to be diffused into the semiconductor layers. The n-type island regions 122 formed improve the charge balance, and thus increase the breakdown voltage, of the device.

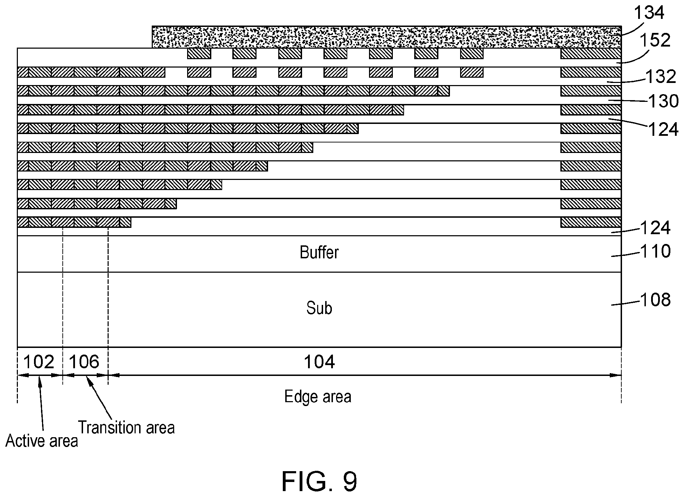

Figure 9 illustrates schematically a fifth set of steps in a method of manufacturing a semiconductor device. The steps of Figure 9 are performed after the steps shown in Figure 8. This involves forming an insulator layer 134 over the n-type island regions 122 in the edge termination region 104. In this example, the insulator layer 134 is an oxide layer, such as silicon dioxide, and can be formed by depositing or thermally growing a silicon dioxide layer over an upper surface of the entire semiconductor substrate and etching the silicon dioxide such that it only covers the edge termination region 104.

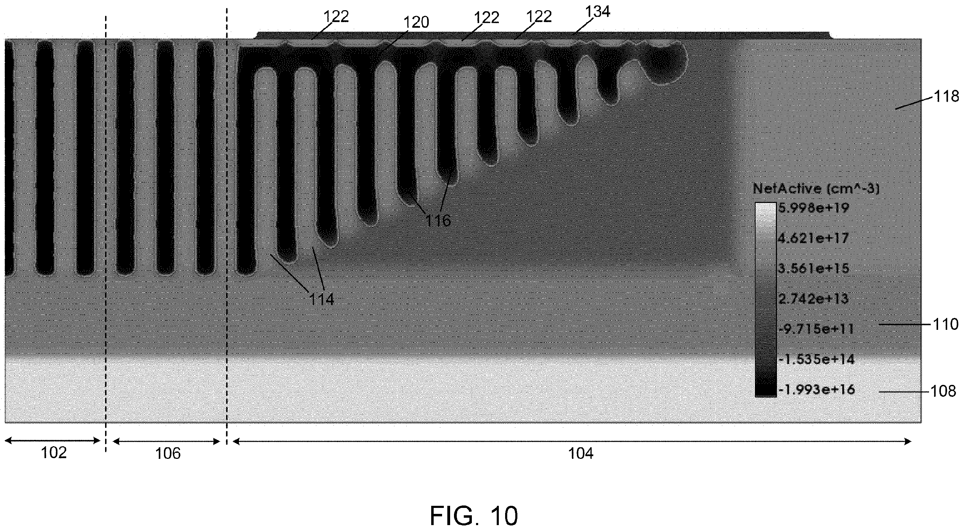

Figure 10 illustrates a doping profile of a device shown in Figure 9.

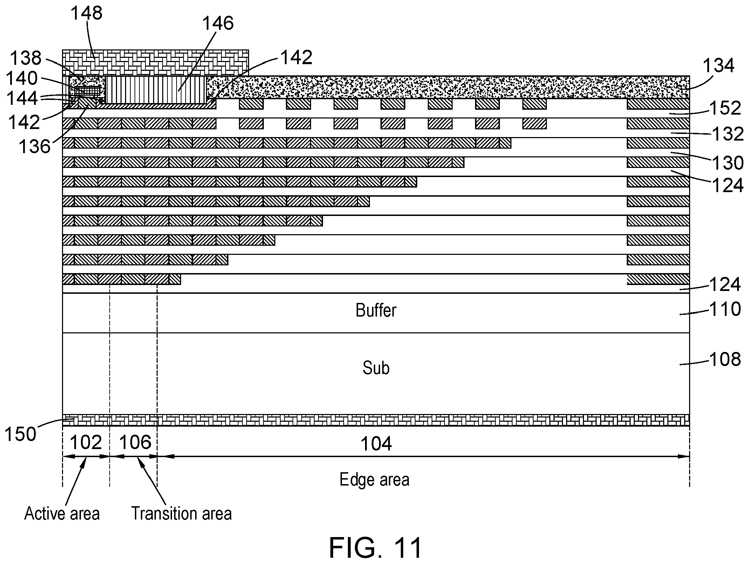

Figure 11 illustrates schematically a sixth set of steps in a method of manufacturing a semiconductor device. The steps of Figure 11 are performed after the steps shown in Figure 9.

The steps of Figure 11 are:
(xv) An area (the JFET region) of the upper surface of the semiconductor substrate within the active region 102 is doped with an n-type impurity to form a JFET n-type region 136. This may be formed in the same way as described in relation to the n-type regions formed in Figures 5, 6, and 8;
(xvi) An interlayer dielectric (ILD (not shown) is deposited;
(xvii) A polysilicon region 140 is deposited in the gate insulation region 140 and over the JFET n-type region 136. The polysilicon region 140 is used to control the conduction channel in the active region. In some examples, the polysilicon region 140 is then etched using a mask such that it doesn't extend over the edge termination region;
(xviii) A p-type body region 142 is formed or implanted at an upper surface of the semiconductor substrate in the active region 102 and the transition region 106;
(xix) Highly doped n+ source regions 144 are formed or implanted either side of the p-type body region 142;
(xx) A gate insulation region 138, is formed over the n-type JFET region 136. The gate insulation region 138 may be an oxide layer, such as silicon dioxide, that can be deposited or thermally grown;
(xxi) An upper surface of the device is etched and highly doped p+ contact regions 146 are implanted in the etched regions;
(xxii) A source metal layer 148 is deposited on a front (upper) surface of the device;
(xxiii) A back (lower) surface of the device is grinded or planarised and a drain metal contact 150 formed.

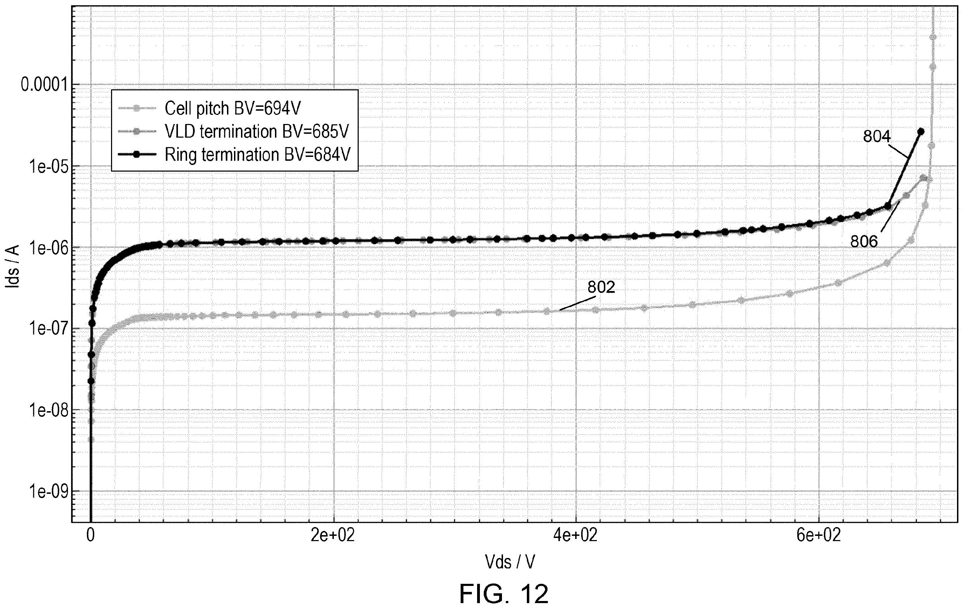

Figure 12 shows simulated breakdown voltage of the edge termination region devices shown in Figures 1 and 2. This shows a reduced breakdown voltage of the device as herein described, compared to state-of-the-art devices. This shows a simulated breakdown voltage (BV) of the active region of a device 802, a VLD edge termination region 806 (such as that shown in Figure 1), and a ring structure edge termination region 804 (such as that shown in Figure 2). The VLD edge termination region and the ring structure edge termination region both have 99% BV of the active region.

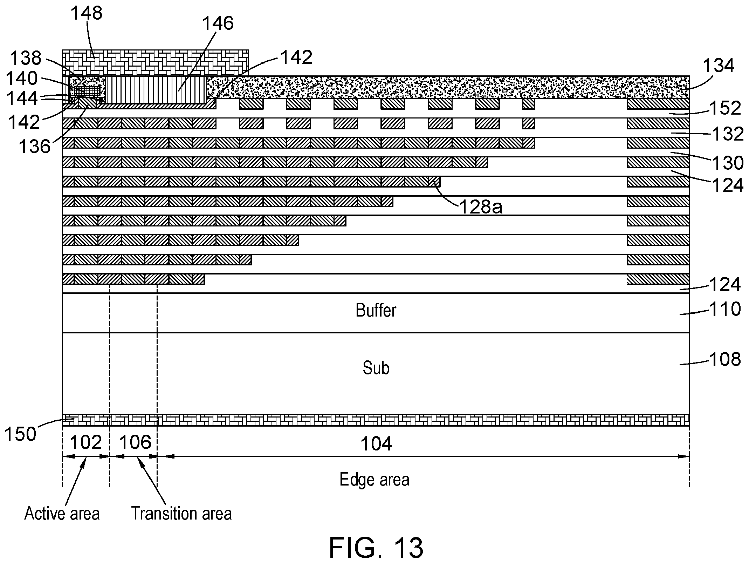

Figure 13 shows an alternative edge termination region of a power semiconductor device according to an embodiment of the disclosure. Many of the features are the same as those shown in Figure 11 and therefore carry the same reference numerals. In this embodiment, during steps (i) to (v), each of the first and second masks are configured such that each semiconductor layer has a p-type partition region 128a closest to the channel stop region rather than an n-drift region 126.

In the example shown in Figure 13, each time step (iv) is performed, the second mask exposes an additional region of the semiconductor layer, such that each layer has an additional p-type partition region 128, wherein only the exposed region of each semiconductor layer 128a that is closest to the side surface of the device is smaller than the others. Each time step (ii) is performed, the first mask also exposes an additional region of the semiconductor layer, such that each layer has an additional n-type drift region 126.

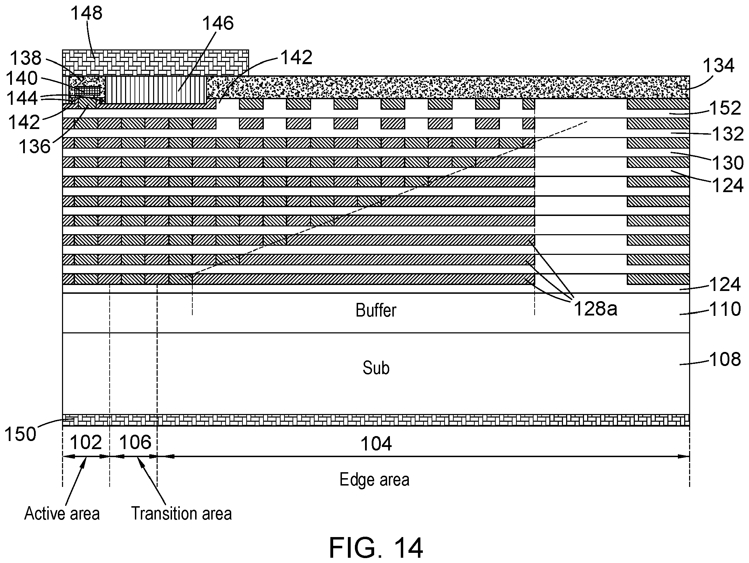

Figure 14 shows an alternative edge termination region of a power semiconductor device according to an embodiment of the disclosure. Many of the features are the same as those shown in Figure 11 and therefore carry the same reference numerals.

In this embodiment, during steps (i) to (v), each of the first and second masks are configured such that each semiconductor layer has a p-type partition region 128a closest to the channel stop region rather than an n-drift region 126.

In the example shown in Figure 14, each time step (iv) is performed, the second mask exposes an additional region of the semiconductor layer, such that each layer has an additional p-type partition region 128, wherein the exposed regions of each of the semiconductor layers that is closest to the side surface of the device have different widths such that they extend to substantially the same lateral position in the device. This forms p-type partition regions 128a closest the side surface of the device that have differing widths, with the partition region 128a of the lowest semiconductor layer having the longest width, and the width of the partition regions decreasing for each semiconductor layer such that the top semiconductor layer 124 has the smallest p-type partition region. Each time step (ii) is performed, the first mask also exposes an additional region of the semiconductor layer, such that each layer has an additional n-type drift region 126.

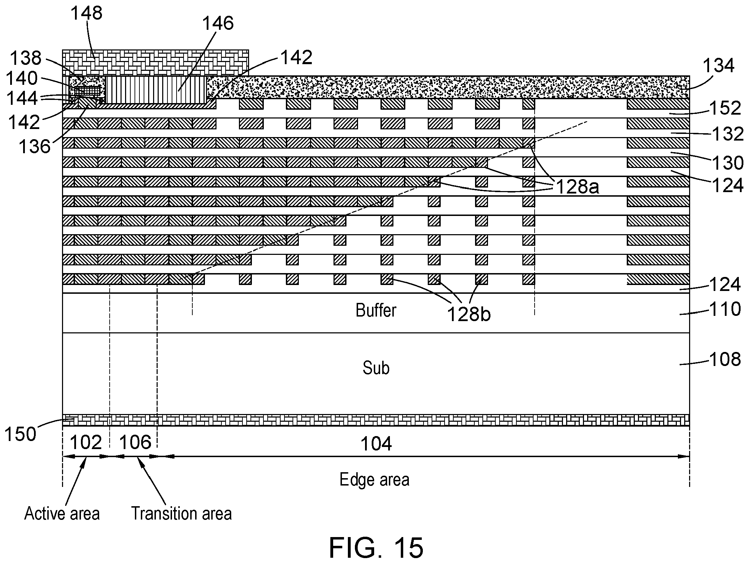

Figure 15 shows an alternative edge termination region of a power semiconductor device according to an embodiment of the disclosure. Many of the features are the same as those shown in Figure 11 and therefore carry the same reference numerals.

In the example shown in Figure 15, each time step (ii) is performed, the first mask exposes an additional region of the semiconductor layer, such that each layer has an additional n-type drift region 126. Each time step (iv) is performed, the second mask exposes a region 128a of the semiconductor layer, adjacent to the additional n-type drift region 126 closest to the side surface of the device, that is smaller than other exposed regions between the smaller region 128a and the active area 102. Additional regions 128b are exposed by the mask in step (iv), these are laterally spaced from the smaller regions 126a at regular intervals, and are the same width as the smaller regions 126a. Each semiconductor layer has a decreasing number of additional regions 128b, the additional exposed regions 128b aligning with the smaller regions 126a of the semiconductor layers 124. The additional p-type regions 128b form floating p-type pillars. These floating p-type pillars can be connected to one another or can be separate. Alternatively, they may connect with adjacent p-type pillars.

### Reference Numerals

- 100: Power semiconductor device
- 102: Active region
- 104: Edge termination region
- 106: Transition region
- 108: n-type substrate
- 110: Buffer region
- 114: n-type pillar
- 116: p-type pillar
- 118: Channel stop region
- 120: p-type layer
- 122: Floating n-type region
- 124: Semiconductor layer
- 126: n-type drift regions
- 128: p-type partition regions
- 130: Semiconductor layer
- 132: Semiconductor layer
- 134: Insulator layer
- 136: JFET n-type region
- 138: Gate insulation region
- 140: Polysilicon region
- 142: p-type body region
- 144: n+ source regions
- 146: p+ contact region
- 148: Source metal layer
- 150: Drain metal layer
- 152: Semiconductor layer
- 154: Gate metal layer
- 156: Polysilicon field plate
- 158: Metal field plate

The skilled person will understand that in the preceding description and appended claims, positional terms such as 'above', `overlap', 'under', 'lateral' etc. are made with reference to conceptual illustrations of an apparatus, such as those showing standard cross-sectional perspectives and those shown in the appended drawings. These terms are used for ease of reference but are not intended to be of limiting nature. These terms are therefore to be understood as referring to a device when in an orientation as shown in the accompanying drawings.

It will be appreciated that all doping polarities mentioned above could be reversed, the resulting devices still being in accordance with embodiments of the present invention.

Although the disclosure has been described in terms of preferred embodiments as set forth above, it should be understood that these embodiments are illustrative only and that the claims are not limited to those embodiments. Those skilled in the art will be able to make modifications and alternatives in view of the disclosure, which are contemplated as falling within the scope of the appended claims. Each feature disclosed or illustrated in the present specification may be incorporated in the disclosure, whether alone or in any appropriate combination with any other feature disclosed or illustrated herein.

## Claims

1. A semiconductor power device having an active region and an edge termination region surrounding the active region, wherein the edge termination region is located laterally between the active region and a side surface of the semiconductor device, the device comprising:
a semiconductor substrate comprising a semiconductor substrate region of a first conductivity type;
a plurality of drift regions of a first conductivity type and a plurality of partition regions of a second conductivity type each disposed over the semiconductor substrate region and alternately in contact with each other, to form a plurality of mutually parallel p-n junctions extending in a vertical direction between adjacent drift regions and partition regions,
wherein, in the edge termination region, two or more partition regions of the plurality of partition regions extend to form a layer of a second conductivity type over two or more drift regions of the plurality of drift regions, and wherein, the depths of adjacent drift regions and partition regions decreases through the edge termination region, from the transition region to the side surface of the device; and
one or more electrically floating regions of a first conductivity type located over the layer of a second conductivity type and within the edge termination region.

2. A semiconductor power device according to claim 1, wherein, in the active area, one or more drift regions of the plurality of drift regions extend such that the partition regions within the active region form physically separated partition regions.

3. A semiconductor power device according to claim 1 or 2, further comprising a plurality of floating pillar regions of a second conductivity type each located under a partition region of a second conductivity type.

4. A semiconductor power device according to any preceding claim, further comprising an insulator layer formed over the electrically floating regions.

5. A semiconductor power device according to any preceding claim, wherein the device further comprises a transition region located laterally between the active region and the edge termination region.

6. A semiconductor power device according to claim 5, wherein the layer of a second conductivity type laterally extends over drift regions of the plurality of drift regions within the transition region.

7. A semiconductor power device according to any preceding claim, wherein each of the plurality of pillars of a second conductivity type comprises a plurality of implant regions of a second conductivity type arranged over one another; and
wherein each of the plurality of pillars of a first conductivity type comprises a plurality of implant regions of a first conductivity type arranged over one another.

8. A semiconductor power device according to any preceding claim, wherein the one or more electrically floating regions of a first conductivity type form a plurality of laterally separated concentric ring structures.

9. A semiconductor power device according to any preceding claim, wherein each one or more electrically floating regions of a first conductivity type have substantially the same width.

10. A semiconductor power device according to any preceding claim, wherein the one or more electrically floating regions of a first conductivity type form a variation of lateral doping (VLD) structure.

11. A semiconductor power device according to any preceding claim, further comprising a buffer region of the first conductivity type located above the semiconductor substrate region of a first conductivity type, and having a lower doping concentration than the semiconductor substrate region of a first conductivity type.

12. A semiconductor power device according to any preceding claim, wherein the device further comprises a channel stop region located laterally between the edge termination structure and a side surface of the semiconductor device and extending to the side surface of the semiconductor device, and
the channel stop region having a higher doping concentration than the drift regions.

13. A semiconductor power device according to any preceding claim, wherein the device comprises a super junction power device.

14. A semiconductor power device according to any preceding claim, wherein the device comprises a metal-oxide semiconductor field-effect transistor (MOSFET).

15. A method of manufacturing a semiconductor power device having an active region and an edge termination region surrounding the active region, wherein the edge termination region is located laterally between the active region and a side surface of the semiconductor device, the method comprising:
providing a semiconductor substrate comprising a first region of a first conductivity type;
forming a plurality of drift regions of a first conductivity type and a plurality of partition regions of a second conductivity type over the semiconductor substrate region and alternately in contact with each other, to form a plurality of mutually parallel p-n junctions extending in a vertical direction between adjacent drift regions and partition regions,
wherein, in the edge termination region, two or more partition regions of the plurality of partition regions extend to form a layer of a second conductivity type over two or more drift regions of the plurality of drift regions, and wherein the depths of adjacent drift regions and partition regions decreases through the edge termination region, from the transition region to the side surface of the device; and
forming one or more electrically floating regions of a first conductivity type located over the layer of a second conductivity type and within the edge termination region.

16. A method according to claim 15, wherein the method of forming the plurality of drift regions and the plurality of partition regions, and forming the one or more electrically floating regions of a first conductivity type, comprises:
performing each of the steps (i) to (v) one or more times:
(i) depositing a semiconductor layer over the semiconductor substrate region;
(ii) forming a first mask over the semiconductor layer, wherein the first mask exposes an upper surface of a first plurality of regions of the semiconductor layer, wherein the first plurality of regions are laterally spaced from each other;
(iii) selectively doping the first plurality of regions of the semiconductor layer to form a first plurality of regions of a first conductivity type;
(iv) forming a second mask over the semiconductor layer, wherein the second mask exposes an upper surface of a second plurality of regions of the semiconductor layer, wherein the second plurality of regions are laterally spaced from each other and located between adjacent regions of the first plurality of regions of a first conductivity type;
(v) selectively doping the second plurality of regions of the semiconductor layer to form a first plurality of regions of a second conductivity type,
wherein each first mask and/or each second mask exposes a further region in addition to the exposed regions of the first mask or second mask on a previously deposited semiconductor layer.

17. A method according to claim 16, wherein an exposed region of the first mask that is closest to the side surface of the device or an exposed region of the second mask that is closest to the side surface of the device has a different width to other exposed regions of the first mask and the second mask between the exposed region closest to the side surface and the active region.

18. A method according to claim 16 or 17, wherein the method further comprises:
depositing a further semiconductor layer over the previously deposited semiconductor layers;
forming a mask over the further semiconductor layer, wherein the mask exposes an upper surface of a plurality of regions of the further semiconductor layer, wherein the regions of the further semiconductor layer are substantially aligned with the plurality of regions of a second conductivity type; and
selectively doping the plurality of regions of the further semiconductor layer to form a plurality of regions of a second conductivity type.

19. A method according to any of claims 16 to 18, wherein the method further comprises:
depositing an additional further semiconductor layer over the previously deposited semiconductor layers;
forming a mask over the additional further semiconductor layer, wherein the mask exposes an upper surface of a plurality of regions of the additional further semiconductor layer,
wherein the regions of the additional further semiconductor layer are substantially aligned with the plurality of regions of a second conductivity type in the edge termination region, and
wherein the mask does not expose the additional further semiconductor layer in the active region; and
selectively doping the plurality of regions of the additional further semiconductor layer to form a plurality of island regions of a first conductivity type in the edge termination region.
